# EUROPEAN PATENT APPLICATION

(11) **EP 4 517 419 A1**
(43) Date of publication of application: **05.03.2025**
(21) Application number: 23814869.6
(22) Date of filing: 28.04.2023
(51) Int. Cl.: G02F 1/1345, G02F 1/133, G09G 3/36

(54) **DISPLAY SUBSTRATE AND DISPLAY DEVICE**

(30) Priority: 31.05.2022 CN 202210609832
(71) Applicant: BOE Technology Group Co., Ltd., Beijing 100015 (CN); Chongqing BOE Optoelectronics Technology Co., Ltd., Chongqing 400714 (CN)
(72) Inventor: WU, Zhongshan, Beijing 100176 (CN); WANG, Xiaoyuan, Beijing 100176 (CN); GUO, Jian Dong, Beijing 100176 (CN); LIU, Yan, Beijing 100176 (CN); CHEN, Junming, Beijing 100176 (CN)
(74) Representative: Isarpatent
(86) International application number: PCT/CN2023/091824
(87) International publication number: WO 2023/231683

(57) **Abstract**

The present application provides a displaying base board and a displaying device, which relates to the technical field of displaying. The displaying base board can greatly reduce the overlapping capacitance between the signal lines, which realizes a low power consumption and a high image quality while satisfying a high refresh rate, to result in a good user experience. The displaying base board includes a displaying region and a peripheral region surrounding the displaying region. The peripheral region contains a plurality of wirings and a driving circuit that is located on one side of the displaying region, and all of the plurality of wirings are electrically connected to the driving circuit, and are located on any one of the two opposite sides of the driving circuit in a first direction, wherein the first direction refers to the direction from the displaying region pointing to the driving circuit. The plurality of wirings include at least a plurality of clock-signal lines and a plurality of power-supply-signal lines. The spacing between at least one of the power-supply-signal lines and the displaying region in the first direction is less than the spacing between at least one of the clock-signal lines and the displaying region in the first direction.

## Description

### CROSS REFERENCE TO RELEVANT APPLICATIONS

The present disclosure claims the priority of the Chinese patent application filed on May 31st, 2022 before the Chinese Patent Office with the application number of 202210609832.8 and the title of "DISPLAY SUBSTRATE AND DISPLAY DEVICE", which is incorporated herein in its entirety by reference.

### TECHNICAL FIELD

The present application relates to the technical field of displaying, and particularly relates to a displaying base board and a displaying device.

### BACKGROUND

With the development of science and technology, Liquid Crystal Displays (LCD) are having increasingly more functions, and the demands on LCDs are increasingly larger. Especially, the demands on high-additional-value display products that integrate multiple functions are higher; for example, it is required that the display products have a high refresh rate.

### SUMMARY

The embodiments of the present application provide a displaying base board and a displaying device.

The embodiments of the present application employ the following technical solutions:

In an aspect, there is provided a displaying base board, wherein the displaying base board comprises a displaying region and a peripheral region surrounding the displaying region;
the peripheral region contains a plurality of wirings and a driving circuit that is located on one side of the displaying region, and all of the plurality of wirings are electrically connected to the driving circuit, and are located on any one of two opposite sides of the driving circuit in a first direction, wherein the first direction refers to a direction from the displaying region pointing to the driving circuit;
the plurality of wirings include at least a plurality of clock-signal lines and a plurality of power-supply-signal lines; and
a spacing between at least one instance of the power-supply-signal lines and the displaying region in the first direction is less than a spacing between at least one instance of the clock-signal lines and the displaying region in the first direction.

Optionally, the driving circuit is located between the displaying region and the plurality of wirings; and
all of the power-supply-signal lines are located between all of the clock-signal lines and the driving circuit.

Optionally, the driving circuit comprises a plurality of shift registers that are cascaded;
at least one instance of the wirings comprises a plurality of first line segments and second line segments, and a quantity of the plurality of first line segments is equal to a quantity of the plurality of shift registers; and
neighboring instances of the first line segments are electrically connected by the second line segments.

Optionally, a width of each of the second line segments in the first direction is less than a width of each of the first line segments in the first direction.

Optionally, each of the first line segments comprises a first sub-line segment and a second sub-line segment that are connected in parallel and arranged side by side, and each of the first sub-line segment and the second sub-line segment is of a double-layer structure.

Optionally, each of the first sub-line segment and the second sub-line segment comprises a first electrically conducting part and a second electrically conducting part that are arranged sequentially in stack; and
the first electrically conducting part and the second electrically conducting part are connected by a via hole; or
the first electrically conducting part and the second electrically conducting part directly contact.

Optionally, each of the first sub-line segment and the second sub-line segment further comprises an insulating part provided between the first electrically conducting part and the second electrically conducting part, the insulating part has the via hole, and the first electrically conducting part is electrically connected to the second electrically conducting part by the via hole in the insulating part.

Optionally, each of the second line segments is of a single-layer structure, and is provided in a same one layer as the second electrically conducting part.

Optionally, all of the clock-signal lines and some of the power-supply-signal lines are of a double-layer structure.

Optionally, the displaying base board further comprises a substrate, and both of the displaying region and the peripheral region are located on the substrate;
the driving circuit comprises a shift register, the shift register comprises a first transistor group and a second transistor group, and the first transistor group is located between the second transistor group and the plurality of wirings; and
the first transistor group comprises a plurality of first transistors, the second transistor group comprises a plurality of second transistors, and an area of an orthographic projection on the substrate of each of the first transistors is less than an area of an orthographic projection on the substrate of each of the second transistors.

Optionally, a spacing in the first direction from the first transistor group to a wiring of a lowest distance among all of the wirings is greater than or equal to 50µm.

Optionally, an active layer of any one of transistors in the first transistor group and the second transistor group comprises a plurality of discrete active parts.

Optionally, the driving circuit comprises a shift register, the shift register comprises a reset unit, and the reset unit is electrically connected to a first reset-signal line, a second reset-signal line, the power-supply-signal lines, and a first node, and is configured for, at a reset stage, under time-division alternating controlling by reset signals of the first reset-signal line and the second reset-signal line, writing power-supply signals in the power-supply-signal lines into the first node in a time-division alternating mode.

Optionally, the displaying base board further comprises an organic layer located on one side of the second electrically conducting part that is farther from the first electrically conducting part, the organic layer has an extending-throughout slot, and the slot is located on one side of all of the clock-signal lines that is farther from the driving circuit; or
the slot is located between the plurality of wirings and the driving circuit.

Optionally, the plurality of wirings further include at least an input-signal line and a reset-signal line, and the input-signal line is located on one side of all of the clock-signal lines that is farther from the driving circuit; and
both of the input-signal line and the reset-signal line are located between all of the clock-signal lines and the driving circuit.

In another aspect, there is provided a displaying device, wherein the displaying device comprises the displaying base board stated above.

An embodiment of the present application provides a displaying base board, wherein the displaying base board comprises a displaying region and a peripheral region surrounding the displaying region, and the peripheral region contains a driving circuit that is located on one side of the displaying region. The peripheral region further contains a plurality of wirings, and all of the plurality of wirings are electrically connected to the driving circuit, and are located on any one of the two opposite sides of the driving circuit in a first direction, wherein the first direction refers to the direction from the displaying region pointing to the driving circuit. The plurality of wirings include at least a plurality of clock-signal lines and a plurality of power-supply-signal lines. The spacing between at least one of the power-supply-signal lines and the displaying region in the first direction is less than the spacing between at least one of the clock-signal lines and the displaying region in the first direction.

The above description is merely a summary of the technical solutions of the present application. In order to more clearly know the elements of the present application to enable the implementation according to the contents of the description, and in order to make the above and other purposes, features and advantages of the present application more apparent and understandable, the particular embodiments of the present application are provided below.

### BRIEF DESCRIPTION OF THE DRAWINGS

In order to more clearly illustrate the technical solutions of the embodiments of the present application or the prior art, the figures that are required to describe the embodiments or the prior art will be briefly described below. Apparently, the figures that are described below are merely embodiments of the present application, and a person skilled in the art can obtain other figures according to these figures without paying creative work.
FIG. 1 is a schematic structural diagram of a displaying base board according to an embodiment of the present application;
FIG. 2 is a schematic structural diagram of another displaying base board according to an embodiment of the present application;
FIG. 3 is an enlarged schematic structural diagram of the clock-signal line CLK1 in FIG. 2;
FIG. 4 is a schematic structural diagram of a displaying base board in the related art;
FIG. 5 is a schematic structural diagram of another displaying base board in the related art;
FIG. 6 is a schematic structural diagram of the active layer in a single TFT according to an embodiment of the present application;
FIG. 7 is a schematic structural diagram of the active layer in a single TFT in the related art;
FIG. 8 is a schematic diagram of a shift register in the related art;
FIG. 9 is a schematic structural diagram of the transistor M1 to the transistor M4 in FIG. 8;
FIG. 10 is a sequence diagram of the driving of the transistors in FIG. 9;
FIG. 11 is a diagram of the output signals of normal displaying of the displaying base board according to an embodiment of the present application;
FIG. 12 is a diagram of the output signals of abnormal displaying of the displaying base board according to an embodiment of the present application;
FIG. 13 is a schematic diagram of a shift register according to an embodiment of the present application;
FIG. 14 is a sequence diagram of the driving of the transistors in FIG. 13;
FIG. 15 is a schematic structural diagram of an ORG slot in the related art;
FIG. 16 is a schematic structural diagram of an ORG slot according to an embodiment of the present application; and
FIG. 17 is a schematic structural diagram of another ORG slot according to an embodiment of the present application.

### DETAILED DESCRIPTION

The technical solutions of the embodiments of the present application will be clearly and completely described below with reference to the drawings of the embodiments of the present application. Apparently, the described embodiments are merely certain embodiments of the present application, rather than all of the embodiments. All of the other embodiments that a person skilled in the art obtains on the basis of the embodiments of the present application without paying creative work fall within the protection scope of the present application.

In the embodiments of the present application, terms such as "first" and "second" are used to distinguish identical items or similar items that have substantially the same functions and effects, merely in order to clearly describe the technical solutions of the embodiments of the present application, and should not be construed as indicating or implying the degrees of importance or implicitly indicating the quantity of the specified technical features.

In the embodiments of the present application, the meaning of "plurality of" is "two or more", and the meaning of "at least one" is "one or more", unless explicitly and particularly defined otherwise.

In the embodiments of the present application, the terms that indicate orientation or position relations, such as "upper", are based on the orientation or position relations shown in the drawings, and are merely for conveniently describing the present application and simplifying the description, rather than indicating or implying that the device or element must have the specific orientation and be constructed and operated according to the specific orientation. Therefore, they should not be construed as a limitation on the present application.

Currently, electronic products such as notebook computers (Notebook, NB) are having increasingly more intense market competition, and it is urgently needed to develop display products that have a high additional value and integrate multiple functions, to win the market. The technique of line driving of array base board (Gate On Array, GOA), because of the advantages such as that it can significantly reduce the usage of integrated circuits (IC) in the display products to reduce the cost and the power consumption of the display products, improve the competitiveness of the products, and thus are being applied increasingly more extensively. The GOA technique is, by using the Thin-Film Transistor (TFT) array manufacture procedure, fabricating the gate scan drive circuits on the displaying base board, to realize the driving mode of progressive scanning.

Currently, some of the display products integrating GOA, for example, notebooks for electronic sports, require an ultra-high refresh rate, so as to provide high-quality frames for dynamic displaying. However, common high-refresh-rate products usually have defects such as a high power consumption and a poor process stability, which results in a very poor user experience. Therefore, further optimization is urgently needed.

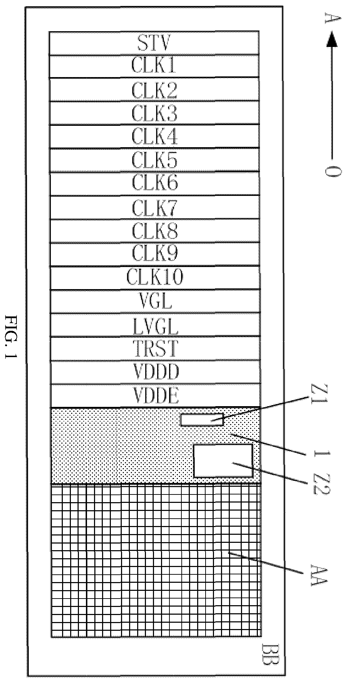

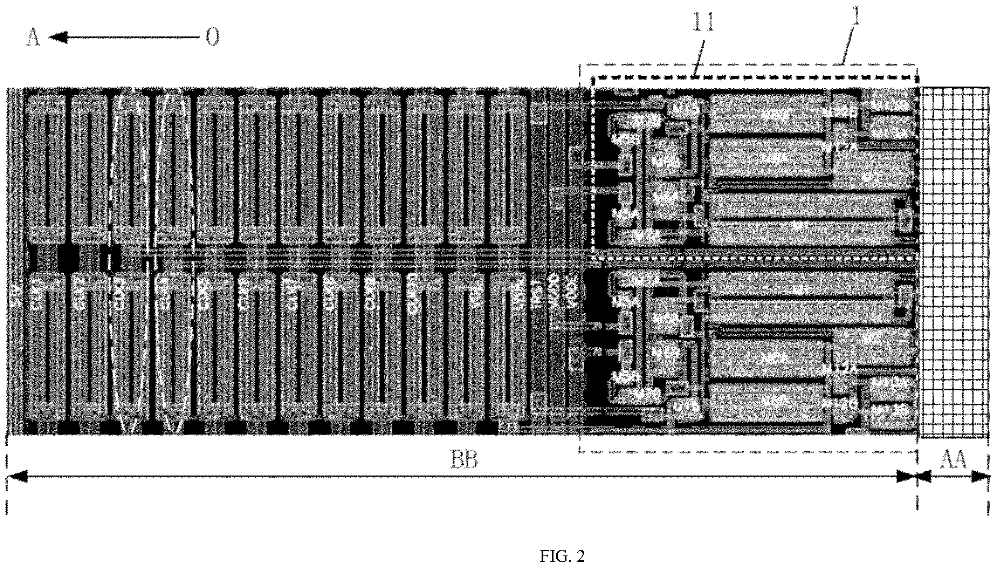

On the basis of the above description, an embodiment of the present application provides a displaying base board. Referring to FIGS. 1 and 2, the displaying base board comprises a displaying region AA and a peripheral region BB surrounding the displaying region AA, and the peripheral region BB contains a driving circuit 1 that is located on one side of the displaying region AA.

Referring to FIGS. 1 and 2, the peripheral region BB further contains a plurality of wirings, and all of the plurality of wirings are electrically connected to the driving circuit 1, and are located on any one of the two opposite sides of the driving circuit 1 in a first direction (the direction OA shown in the figures), wherein the first direction refers to the direction from the displaying region AA pointing to the driving circuit 1. The plurality of wirings include at least a plurality of clock-signal lines CLK and a plurality of power-supply-signal lines.

Referring to FIGS. 1 and 2, the spacing between at least one of the power-supply-signal lines and the displaying region AA in the first direction is less than the spacing between at least one of the clock-signal lines CLK and the displaying region AA in the first direction.

The displaying region (Active Area, AA) of the displaying base board refers to the region used to implement the displaying.

The peripheral region refers to the region outside the displaying region, is also referred to as the border-frame region, and is usually used to provide a driving wiring and a driving circuit (for example, a GOA driving circuit), or used to provide an in-screen camera, an earphone, a loudspeaker and so on. The peripheral region surrounds the displaying region by one circle. FIG. 1 illustrates by taking the case as an example in which the peripheral region BB surrounds the displaying region AA by one circle. FIG. 2 merely illustrates the peripheral region BB located on one side of the displaying region AA.

The peripheral region contains a driving circuit that is located on one side of the displaying region. The peripheral region may contain one driving circuit located on one side of the displaying region. For example, one driving circuit is located on one side among the left side, the right side, the upper side and the lower side of the displaying region. Alternatively, the peripheral region may also contain two driving circuits located on the two opposite sides of the displaying region. For example, two driving circuits are located on the left side and the right side of the displaying region. Alternatively, two driving circuits are located on the upper side and the lower side of the displaying region.

The type of the driving circuit is not particularly limited herein. As an example, the driving circuit may include a GOA circuit, and the GOA circuit may particularly include a gate GOA circuit.

That the plurality of wirings are located on any one of the two opposite sides of the driving circuit in the first direction refers to that the plurality of wirings are located on the side of the driving circuit that is closer to the displaying region in the first direction, or that the plurality of wirings are located on the side of the driving circuit that is farther from the displaying region in the first direction. Both of FIGS. 1 and 2 illustrate by taking the case as an example in which the plurality of wirings are located on the side of the driving circuit 1 that is farther from the displaying region AA in the direction OA; particularly, the driving circuit 1 is located between the plurality of wirings and the displaying region AA in the direction OA.

The material of the wirings is not particularly limited herein. As an example, the material of the wirings may include a metal and so on.

The type of the power-supply-signal lines is not particularly limited herein. As an example, the power-supply-signal lines may include a first power-supply-signal line VGL, a second power-supply-signal line LVGL, a third power-supply-signal line VDDO, a fourth power-supply-signal line VDDE and so on.

That the spacing between at least one of the power-supply-signal lines and the displaying region in the first direction is less than the spacing between at least one of the clock-signal lines and the displaying region in the first direction refers to that at least one of the power-supply-signal lines is closer to the displaying region in the first direction than at least one of the clock-signal lines is. The at least one of the power-supply-signal lines may refer to one power-supply-signal line, two power-supply-signal lines, three power-supply-signal lines, and so on, and may also refer to all of the power-supply-signal lines. Likewise, the at least one of the clock-signal lines may refer to one clock-signal line, two clock-signal lines, three clock-signal lines, and so on, and may also refer to all of the clock-signal lines. In this case, the positions of the at least one of the power-supply-signal lines and the at least one of the clock-signal lines with the displaying region are not particularly limited. As an example, the at least one of the power-supply-signal lines is located between the at least one of the clock-signal lines and the displaying region in the first direction. Alternatively, the at least one of the power-supply-signal lines is not located between the at least one of the clock-signal lines and the displaying region in the first direction. Both of FIGS. 1 and 2 illustrate by taking the case as an example in which the at least one of the power-supply-signal lines is located between the at least one of the clock-signal lines CLK and the displaying region AA in the direction OA.

The first direction may be the direction OA shown in FIGS. 1 and 2, and may also be the direction opposite to the direction OA, which may be decided particularly according to practical situations.

The displaying base board may be a flexible displaying base board, and may also be a rigid displaying base board, which is not limited herein. All of the embodiments of the present application illustrate by taking the case as an example in which the displaying base board is a rigid displaying base board.

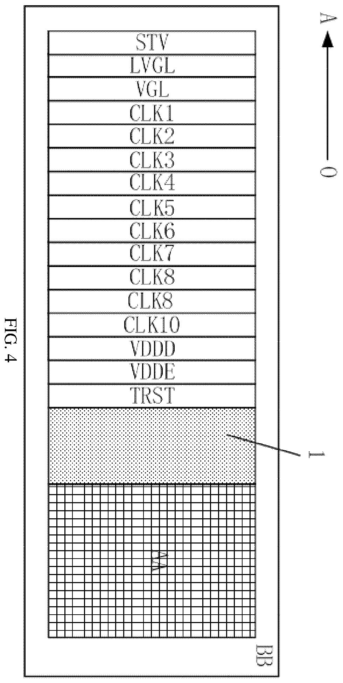

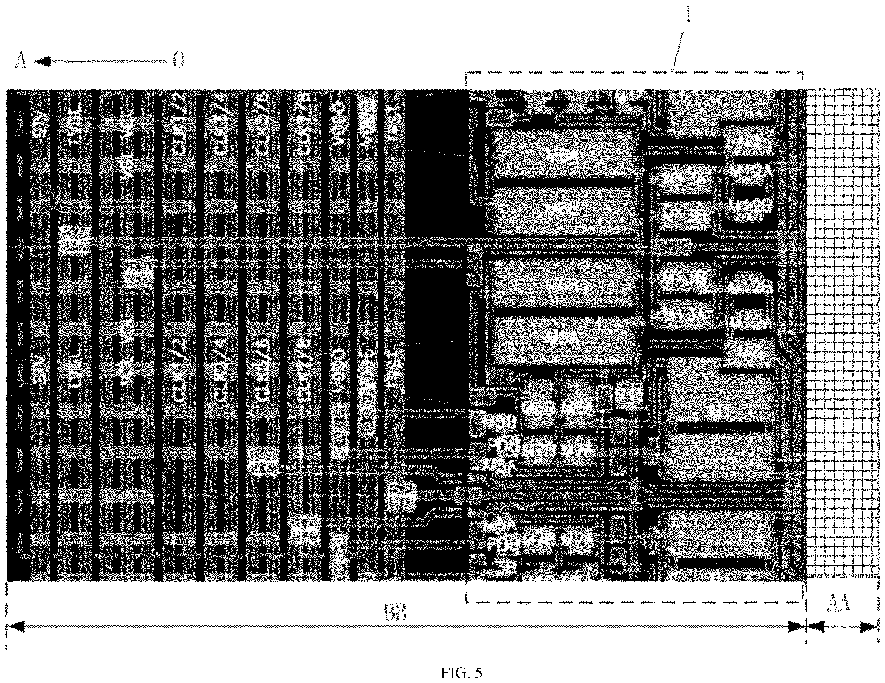

Both of FIGS. 4 and 5 are a schematic diagram of the wiring arrangement in the related art. Both of FIGS. 4 and 5 illustrate by taking the case as an example in which the driving circuit 1 is located between the plurality of wirings and the displaying region AA. Referring to FIGS. 4 and 5, both of the power-supply-signal line VGL and the power-supply-signal line LVGL are located on the side of the clock-signal lines CLK that is farther from the driving circuit 1 (FIGS. 4 and 5 contain ten clock-signal lines CLK, which are the clock-signal lines CLK1-CLK10). Because all of the clock-signal lines CLK, the power-supply-signal line VGL and the power-supply-signal line LVGL are electrically connected to the driving circuit, the power-supply-signal line VGL and the power-supply-signal line LVGL are required to cross all of the clock-signal lines CLK, thereby forming a high overlapping capacitance, which significantly increases the power consumption of the driving circuit.

An embodiment of the present application provides a displaying base board, wherein the displaying base board comprises a displaying region and a peripheral region surrounding the displaying region, and the peripheral region contains a driving circuit that is located on one side of the displaying region. The peripheral region further contains a plurality of wirings, and all of the plurality of wirings are electrically connected to the driving circuit, and are located on any one of the two opposite sides of the driving circuit in a first direction, wherein the first direction refers to the direction from the displaying region pointing to the driving circuit. The plurality of wirings include at least a plurality of clock-signal lines and a plurality of power-supply-signal lines. The spacing between at least one of the power-supply-signal lines and the displaying region in the first direction is less than the spacing between at least one of the clock-signal lines and the displaying region in the first direction. Accordingly, by configuring that the at least one of the power-supply-signal lines is closer to the displaying region than the at least one of the clock-signal lines is, because the clock-signal lines input the signals to one row of the driving circuits line by line and row by row, merely one clock-signal line crosses the at least one of the power-supply-signal lines, which can greatly reduce the overlapping capacitance between the signal lines, so as to satisfy the demands on a low power consumption, a high image quality and a high refresh rate, thereby effectively ensuring the performance of the displaying base board.

Optionally, referring to FIGS. 1 and 2, the driving circuit 1 is located between the displaying region AA and the plurality of wirings, and all of the power-supply-signal lines are located between all of the clock-signal lines CLK and the driving circuit 1. Therefore, all of the power-supply-signal lines are closer to the displaying region than all of the clock-signal lines are, to ensure that merely one clock-signal line crosses all of the power-supply-signal lines, which can reduce the overlapping capacitance between the signal lines to the largest extent, thereby more effectively ensuring the performance of the displaying base board.

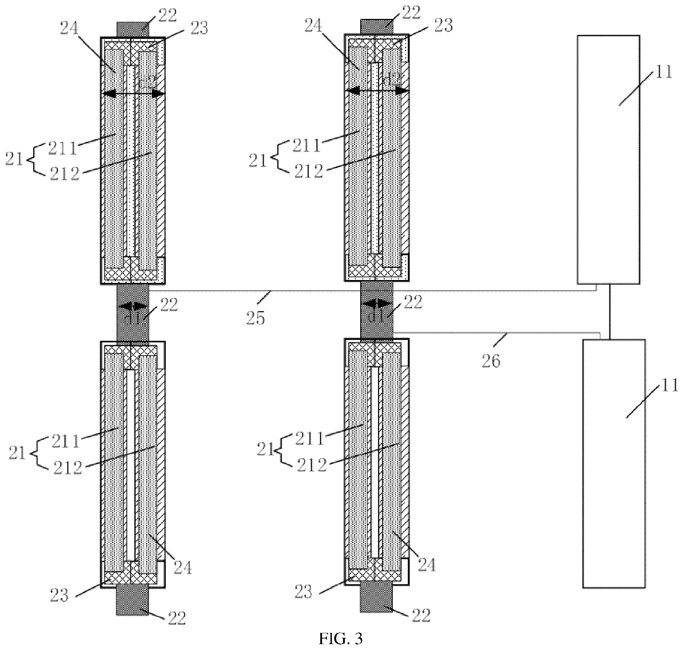

Optionally, referring to FIGS. 2 and 3, the driving circuit 1 comprises a plurality of shift registers 11 that are cascaded. At least one of the wirings comprises a plurality of first line segments 21 and second line segments 22, and the quantity of the first line segments 21 is equal to the quantity of the shift registers 11. Neighboring first line segments 21 are electrically connected by the second line segments 22.

The plurality of shift registers are cascaded, so that the output signal of the preceding order of the shift registers can serve as the input signal of the subsequent order of the shift registers.

When the clock-signal line CLK3 and the clock-signal line CLK4 in the dotted-line circles shown in FIG. 2 are enlarged, the schematic structural diagram of the clock-signal line CLK3 and the clock-signal line CLK4 shown in FIG. 3 is obtained. FIG. 3 illustrates by taking the case as an example in which each of one clock-signal line CLK3 and one clock-signal line CLK4 comprises two first line segments 21 and three second line segments 22, in which case the driving circuit 1 comprises two shift registers 11 that are cascaded.

The structure of the first line segments is not particularly limited. As an example, the first line segments may be of a single-layer structure. Alternatively, the first line segments may be of a multilayer structure. Both of FIGS. 2 and 3 illustrate by taking the case as an example in which the first line segments are of a double-layer structure.

The structure of the second line segments is not particularly limited. As an example, the second line segments may be of a single-layer structure. Alternatively, the second line segments may be of a multilayer structure. Both of FIGS. 2 and 3 illustrate by taking the case as an example in which the second line segments are of a single-layer structure.

It should be noted that, firstly, the clock-signal lines CLK are electrically connected to the shift registers by connecting line segments. Particularly, the connecting line segments are directly connected to the second line segments of the clock-signal lines CLK. In the case in which the plurality of wirings comprise a plurality of first line segments and a plurality of second line segments, the connecting line segments that connect the second line segments of one wiring and the shift registers have an overlapping part with the second line segments of the other wirings in the direction OA. FIG. 3 illustrates by taking the case as an example in which the clock-signal line CLK3 is electrically connected to the shift registers 11 by a connecting line segment 25 and the clock-signal line CLK4 is electrically connected to the shift registers 11 by a connecting line segment 26. Referring to FIG. 3, the connecting line segment 25 and the second line segment 22 of the clock-signal line CLK4 have an overlapping part in the direction OA.

Secondly, the dotted lines in the figures do not represent particular components, are not practically meaningful, and are merely schematic diagrams illustrated for the purpose of better describing the structures of the present application.

In the related art, referring to FIGS. 4 and 5, all of the plurality of wirings are of a single-layer structure. Because increasingly more NB products are having increasingly higher sizes, and, in the direction perpendicular to the first direction (the direction OA), the plurality of wirings extend increasingly farther, the current single-layer metal wirings have already become incapable of satisfying the requirement on the impedance by high-refresh-rate products.

In the displaying base board according to the embodiments of the present application, within the non-line-crossing region, double-layer metal wirings are provided, which can effectively reduce the wiring resistance within, for example, the region of the clock-signal lines CLK, thereby reducing the delay time of the output signal of the driving circuit, and effectively reducing the power consumption of the driving circuit.

Optionally, referring to FIG. 3, the width d1 of each of the second line segments 22 in the first direction is less than the width d2 of each of the first line segments 21 in the first direction. Accordingly, in an aspect, the overlapping capacitance of the line-crossing region can be effectively reduced. In another aspect, the impedance of the second line segments can be reduced, to improve the capacity of driving of the driving circuit, and improve the brightness uniformity of the displaying base board.

The width of each of the second line segments in the first direction is not particularly limited herein. As an example, the width d1 of each of the second line segments in the first direction may range 15µm-18µm, for example, 15µm, 16µm, 17µm, or 18µm.

Optionally, referring to FIG. 3, each of the first line segments 21 comprises a first sub-line segment 211 and a second sub-line segment 212 that are connected in parallel and arranged side by side, and each of the first sub-line segment 211 and the second sub-line segment 212 is of a double-layer structure. Accordingly, each of the double-layer metal wirings within the non-line-crossing region comprises four line segments, which more effectively reduces the wiring resistance within, for example, the region of the clock-signal lines CLK, thereby further reducing the delay time of the output signal of the driving circuit, and further reducing the power consumption of the driving circuit.

The mode of how the first sub-line segment and the second sub-line segment are connected in parallel is not particularly limited herein. As an example, the first sub-line segment and the second sub-line segment may be connected in parallel by a via hole. FIG. 3 illustrates by taking the case as an example in which all of the first sub-line segments 211 and the second sub-line segments 212 are connected in parallel by via holes 23.

How the double layers are connected in parallel is not particularly limited herein. As an example, the double layers may be directly connected in parallel. Alternatively, the double layers may be connected in parallel by a via hole.

The present application provides a mode of the parallel connection between the first sub-line segment and the second sub-line segment. Optionally, each of the first sub-line segment and the second sub-line segment comprises a first electrically conducting part and a second electrically conducting part that are arranged sequentially in stack, and the first electrically conducting part and the second electrically conducting part are connected by a via hole. That can very effectively reduce the overlapping capacitance and the wiring resistance between the wirings, thereby reducing the power consumption of the driving circuit, the delay time of the displaying base board, and so on, to greatly improve the image quality of high-refresh-rate products.

The material of the first electrically conducting part and the second electrically conducting part is not particularly limited herein. As an example, the material of the first electrically conducting part and the second electrically conducting part may include a metal.

The present application provides another mode of the parallel connection between the first sub-line segment and the second sub-line segment. Optionally, each of the first sub-line segment and the second sub-line segment comprises a first electrically conducting part and a second electrically conducting part that are arranged sequentially in stack, and the first electrically conducting part and the second electrically conducting part directly contact. That simplifies the fabrication, and is simple and easy to implement.

Optionally, each of the first sub-line segment and the second sub-line segment further comprises an insulating part provided between the first electrically conducting part and the second electrically conducting part, the insulating part has the via hole, and the first electrically conducting part is electrically connected to the second electrically conducting part by the via hole in the insulating part.

The material of the insulating part is not particularly limited herein. As an example, the material of the insulating part may include silicon oxide or silicon nitride.

In the case in which the displaying base board further comprises a gate layer (Gate), an insulating layer and a source-drain metal layer (SD layer) that are arranged sequentially in stack, the first electrically conducting part and the Gate layer are arranged in the same one layer, and the second electrically conducting part and the SD layer are arranged in the same one layer.

The above-described arrangement in the same one layer refers to that they are fabricated by using a one-step patterning process. The one-step patterning process refers to a process in which the required layer structure is formed by a single exposure. The one-step patterning process comprises the processes of masking, exposure, development, etching, stripping and so on.

Optionally, referring to FIG. 3, each of the second line segments 22 is of a single-layer structure, and is provided in the same one layer as the second electrically conducting part. Accordingly, the neighboring first line segments can be electrically connected by using a simple fabricating process, and the overall fabricating process is simple and easy to operate.

The second electrically conducting part may be the SD layer, which may be decided particularly according to practical situations.

Optionally, referring to FIG. 2, all of the clock-signal lines CLK and some of the power-supply-signal lines are of a double-layer structure. Accordingly, the wiring resistance within, for example, the region of the clock-signal lines CLK can be more effectively reduced by using the clock-signal lines and the power-supply-signal lines, thereby further reducing the delay time of the output signal of the driving circuit, and further reducing the power consumption of the driving circuit.

FIG. 2 illustrates by taking the case as an example in which all of the clock-signal lines CLK1-10, the power-supply-signal line VGL and the power-supply-signal line LVGL are of a double-layer structure, and all of the power-supply-signal line VDDE, the power-supply-signal line VDDO and the reset-signal line TRST are of a single-layer structure. In this case, the wiring design can be effectively performed, to save the room, thereby realizing a narrow border frame better.

Optionally, the displaying base board further comprises a substrate, and both of the displaying region and the peripheral region are located on the substrate.

Referring to FIGS. 1 and 2, the driving circuit comprises a shift register, the shift register comprises a first transistor group Z1 and a second transistor group Z2, and the first transistor group Z1 is located between the second transistor group Z2 and the plurality of wirings. The first transistor group Z1 comprises a plurality of first transistors, the second transistor group Z2 comprises a plurality of second transistors, and the area of the orthographic projection on the substrate of each of the first transistors is less than the area of the orthographic projection on the substrate of each of the second transistors.

The material of the substrate is not limited. It may comprise a rigid material, for example, a glass. Alternatively, it may also comprise a flexible material, for example, polyimide (PI).

The size of the transistors in the first transistor group is not particularly limited herein. As an example, the size of the transistors ranges 1µm-50µm, for example, 1µm, 10µm, 20µm, 30µm, 40µm, or 50µm.

The type of the transistors in the first transistor group and the second transistor group is not particularly limited herein. As an example, the transistors in the transistor groups may include TFT, and may particularly include an oxide TFT, for example, an Indium Gallium Zinc Oxide (IGZO) type TFT.

The quantity of the first transistors comprised by the first transistor group is not particularly limited herein. As an example, the quantity of the first transistors comprised by the first transistor group may be one. Alternatively, the quantity of the first transistors comprised by the first transistor group may be plural. FIG. 2 illustrates by taking the case as an example in which the first transistor group of one shift register comprises 7 transistors, for example, the transistor M15, the transistor M7B, the transistor M5B, the transistor M6B, the transistor M6A, the transistor M5A and the transistor M7A marked in FIG. 2. In the case in which the first transistor group comprises a plurality of first transistors, the sizes of all of the first transistors are not particularly limited. As an example, the sizes of all of the first transistors may be equal. Alternatively, the sizes of all of the first transistors may be unequal. Alternatively, the sizes of some of the first transistors may be equal.

The quantity of the second transistors comprised by the second transistor group is not particularly limited herein. As an example, the quantity of the second transistors comprised by the second transistor group may be one. Alternatively, the quantity of the second transistors comprised by the second transistor group may be plural. FIG. 2 illustrates by taking the case as an example in which the second transistor groups of two shift registers comprise 8 transistors, for example, the transistor M1, the transistor M2, the transistor M8B, the transistor M12B, the transistor M13B, the transistor M8A, the transistor M12A and the transistor M13A marked in FIG. 2. In the case in which the second transistor group comprises a plurality of second transistors, the sizes of all of the second transistors are not particularly limited. As an example, the sizes of all of the second transistors may be equal. Alternatively, the sizes of all of the second transistors may be unequal. Alternatively, the sizes of some of the second transistors may be equal.

In the related art, referring to FIG. 5, as corresponding to the region of the displaying base board that is covered by the frame sealing adhesive (Seal adhesive), the transistors of a higher size such as M8A and M8B are provided, for example, TFTs. Accordingly, when the displaying base board has a narrow border frame, the large-block metals in the TFTs of a higher size affect the light transmittance. Because the Seal adhesive requires solidification by ultraviolet light (UV) to serve to seal the frame, the large-block metals in those TFTs of a higher size affect the solidification of the Seal adhesive by the UV light. Moreover, some of the TFTs of a higher size are used to realize the function of denoising of the shift registers, and the higher size requires a longer UV illumination duration. However, the longer UV illumination duration might damage those TFTs of a higher size, which results in a characteristic imperfect.

In the shift registers according to the embodiments of the present application, the area of the orthographic projection on the substrate of each of the first transistors is less than the area of the orthographic projection on the substrate of each of the second transistors, and the first transistors are located between the second transistors and the plurality of wirings. In other words, as shown in FIG. 2, the transistors of a lower size marked by M5B and so on are provided on the side closer to the wirings, and the transistors of a higher size marked by M8B and so on are provided on the side farther from the wirings, whereby all of the transistors of a lower size are closer to the wirings such as the clock-signal lines CLK. Because the metals in the transistors of a lower size also have a lower area, that can reduce the blocking by the transistors to the frame sealing adhesive to the largest extent, to increase the UV-illumination transmittance, which can ensure the performance of the displaying base board while optimizing the narrow border frame of the displaying base board.

Optionally, the spacing in the first direction from the first transistor group to a wiring of the lowest distance among all of the wirings is greater than or equal to 50µm.That can prevent Electro-Static discharge (referred to for short as ESD) of the displaying base board, which results in burning imperfect of the signal lines.

As an example, the spacing may be 50µm, 60µm, 70µm and so on.

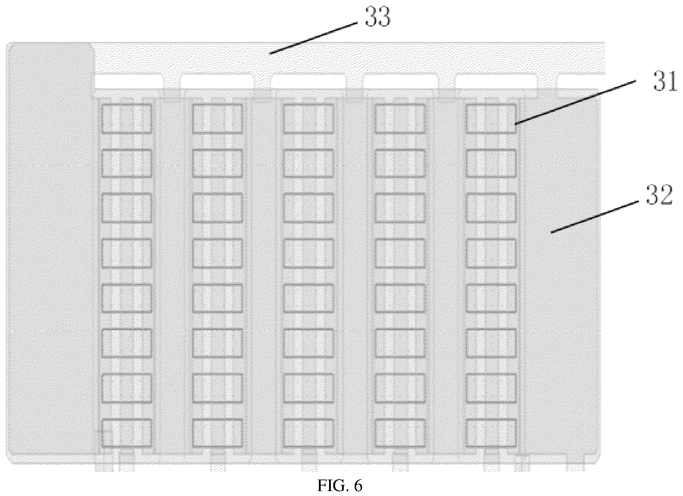

Optionally, referring to FIG. 6, an active layer of any one of transistors in the first transistor group and the second transistor group comprises a plurality of discrete active parts 31.

The range of the spacing between the neighboring active parts is not particularly limited herein. As an example, the spacing between the neighboring active parts ranges 1µm-7µm, for example, 1µm, 3µm, 5µm or 7µm. When the spacing between the neighboring active parts is 5µm, that is very beneficial to improving the stability of the threshold voltage (Vth) of the shift registers.

The shape of the active parts of any one of the transistors is not particularly limited herein. As an example, the shape of the orthographic projection on the substrate of each of the active parts may be a rectangle and so on.

The size of the active parts of any one of the transistors is not particularly limited herein. As an example, in the case in which any one of the transistors is a TFT and the shape of the orthographic projection on the substrate of each of the active parts of the TFT is a rectangle, the length of each of the active parts of any one of the TFTs ranges 5µm-10µm, for example, 5µm, 7µm, 8µm or 10µm. The width of each of the active parts of any one of the TFTs ranges 5µm-7µm, for example, 5µm, 6µm or 7µm.

The quantity and the arrangement mode of the active parts are not particularly limited herein. As an example, the active parts may be arranged in a 5×5 matrix.

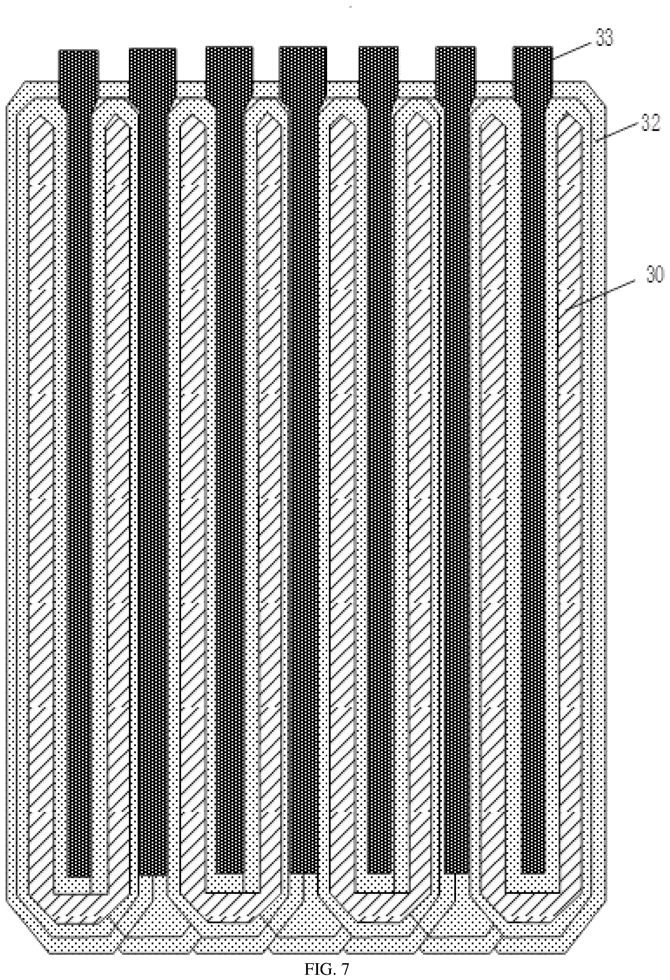

It should be noted that FIGS. 6 and 7 further show the gate 32, the source and the drain 33 of one TFT.

In the related art, referring to FIG. 7, the active layer 30 of the TFT is an overall large block. In this case, for an oxide TFT, it has a high mobility, and Vth characteristic drift very easily happens, accompanied by imperfects such as heat generation. In the transistors according to the embodiments of the present application, the active layer 30 as the large block in FIG. 7 is split into a plurality of discrete active parts 31 in FIG. 6; in other words, all of the active parts 31 in FIG. 6 are equivalent to one active layer 30 in FIG. 7. Accordingly, the active layers are designed separately in a plurality of groups, which facilitates to improve the Vth stability of the TFT.

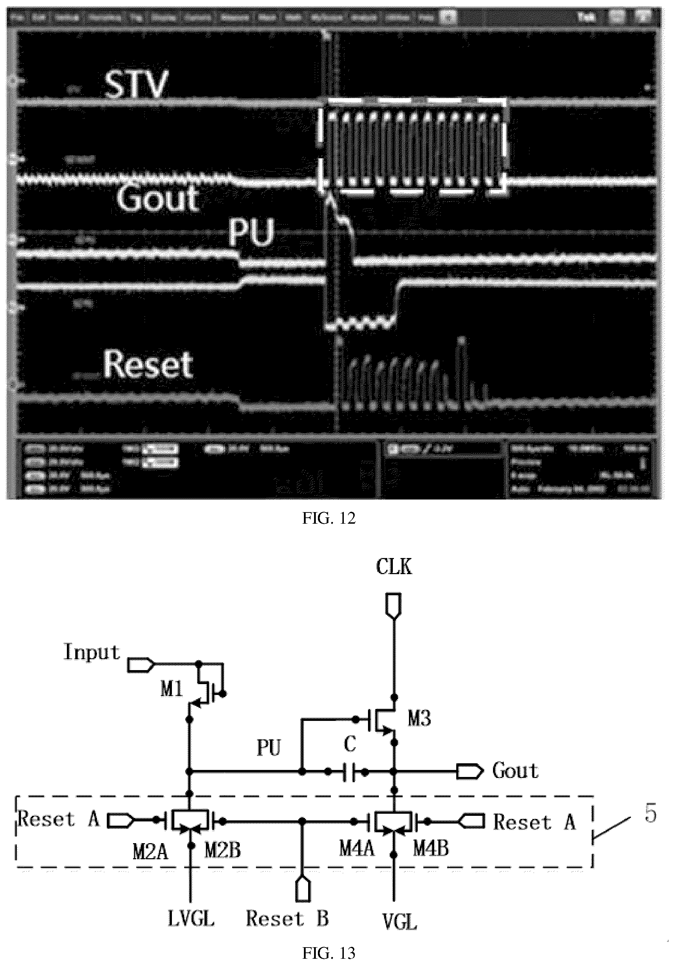

Optionally, referring to FIG. 13, the driving circuit comprises a shift register, the shift register comprises a reset unit 5, and the reset unit 5 is electrically connected to a first reset-signal line Reset A, a second reset-signal line Reset B, the power-supply-signal lines, and a first node PU, and is configured for, at a reset stage, under the time-division alternating controlling by the reset signals of the first reset-signal line Reset A and the second reset-signal line Reset B, writing the power-supply signals in the power-supply-signal lines into the first node PU in a time-division alternating mode.

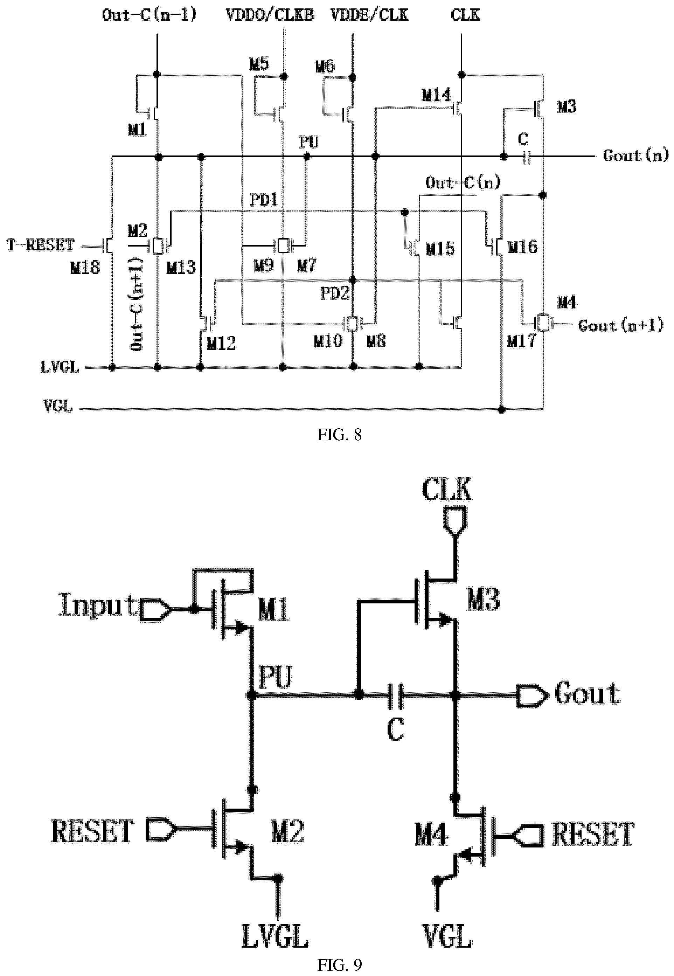

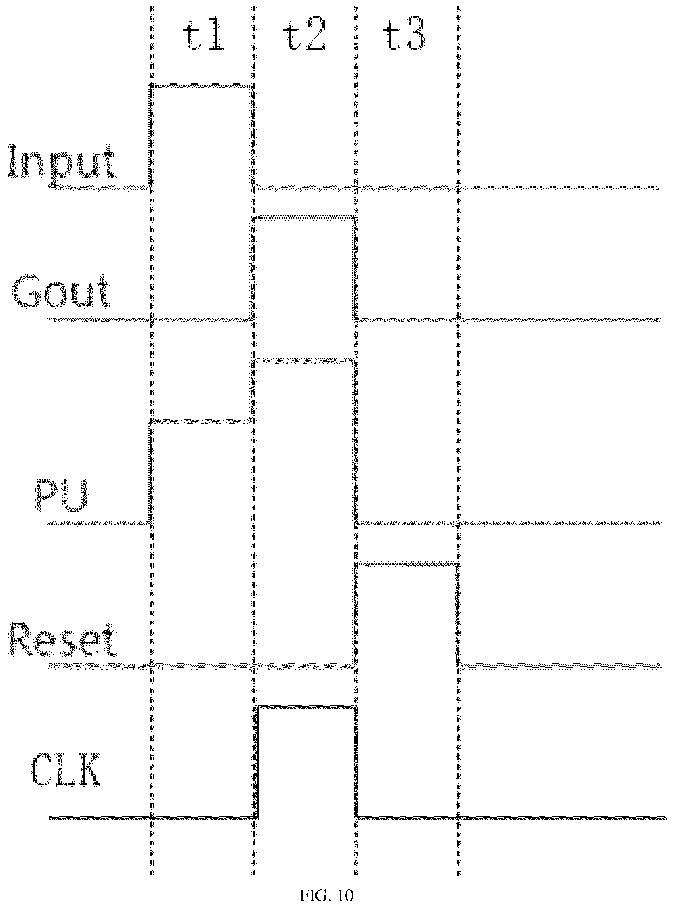

In the related art, the TFTs forming the GOA circuit are of multiple types, wherein one of the types is an oxide TFT. The conventional oxide TFTs, when employing the conventional 18T1C driving architecture shown in FIG. 8, have the problem of an unstable reliability of a certain or some TFTs, and, accordingly, after long-time usage, because of the damage on the TFT characteristics, the display product has transverse-stripe imperfect. Regarding some of the TFTs in FIG. 8, particularly, the circuit shown in FIG. 9 formed by TFT1, TFT2, TFT3 and TFT4, by referring to the time sequence shown in FIG. 10, the reason for the transverse-stripe imperfect of the display product will be particularly described.

Referring to FIG. 9, the transistor M1 is electrically connected to the signal line Input and the first node PU, and is configured for, under the controlling by the Input signal of the signal line Input, writing the Input signal of the signal line Input into the first node PU and the capacitor C. The transistor M3 is electrically connected to the clock-signal line CLK, the first node PU and the capacitor C, and is configured for, under the controlling by the Input signal of the first node PU, writing the CLK signal of the clock-signal line CLK into the output-signal line Gout. The transistor M2 is electrically connected to the signal line RESET and the power-supply-signal line LVGL, and is configured for, under the controlling by the RESET signal of the signal line RESET, writing the LVGL signal of the power-supply-signal line LVGL into the first node PU. The transistor M4 is electrically connected to the signal line RESET and the power-supply-signal line VGL, and is configured for, under the controlling by the RESET signal of the signal line RESET, writing the VGL signal of the power-supply-signal line VGL into the output-signal line Gout.

The operation principle of the GOA circuit shown in FIG. 9 will be described in detail below by taking the case as an example in which the transistors M1-M4 are N-type transistors and by referring to the sequence diagrams of the signal lines shown in FIG. 10.

Referring to FIG. 10, at the stage t1, a high level is inputted into the signal line Input, and at this point the transistor M1 is turned on, the first node PU is pulled up to a high level, and the capacitor C is charged. At the stage t2, the transistor M3 is turned on, to input a high level into the clock-signal line CLK, and at this point the output-signal line Gout outputs a high level. Because of the bootstrapping effect of the capacitor C, the first node PU is boosted again. At the stage t3, a high level is inputted into the signal line RESET, and at this point the transistor M2 and the transistor M4 are turned on, to write the low levels inputted by LVGL and VGL respectively into the first node PU, and pull down the first node PU to a low level, and the output-signal line Gout outputs a low level.

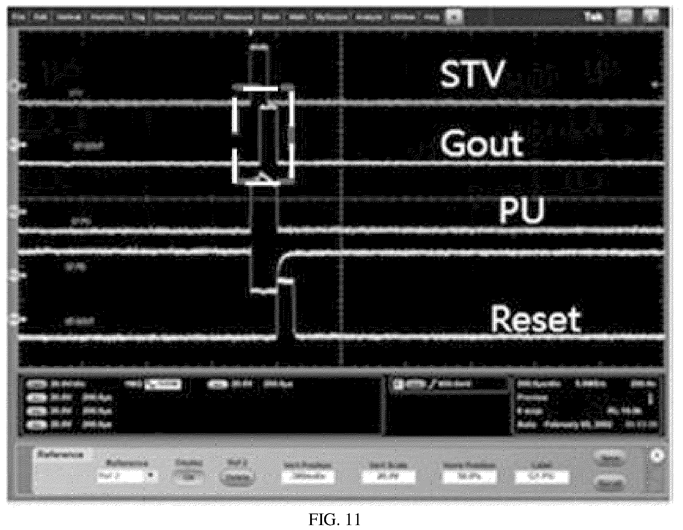

In the above-described process, the signal line Input outputs the high level, to turn on the transistor M1, and the first node PU changes into the high level, to also turn on the transistor M3. Subsequently, the clock-signal line CLK inputs the high level, and the output-signal line Gout outputs the high level; for example, the high level is 22V. Because of the bootstrapping effect of the capacitor C, the first node PU can be boosted again, for example, boosted to a higher voltage of 22V-44V. Therefore, when the signal line RESET is inputted the low level to turn on the transistor M2 and/or the transistor M4, for example, the transistor M2 is inputted a LVGL low level of-11V, which causes that the voltage difference Vds between the source and the drain of the transistor M2 might reach 33V-55V. In other words, the source and the drain of the transistor M2 have a high voltage difference Vds therebetween. If the transistor M2 has a good voltage-resisting capacity, the output-signal line Gout normally outputs the signal shown in FIG. 11. However, if the voltage-resisting capacity of the transistor M2 is insufficient, the transistor M2 very easily has a characteristic damage. Therefore, the characteristic damage of the transistor M2 causes that the first node PU cannot be pulled down, and the transistor M3 is turned on for a long time, which causes that the output-signal line Gout has multiple outputs, and the transverse-stripe imperfect shown in FIG. 12 happens.

It has been found by studying the oxide transistor M2 of multiple mainstream products in the related art that, when the active layer of the oxide transistor M2 has a high length, for example, when the length reaches 35.8µm, the heat generation of the oxide transistor M2 becomes more severe. On that basis, if the oxide transistor M2 has a low overall width, for example, merely 366µm, and large blocks of the SD metals are connected, the capacity of heat dissipation of the oxide transistor M2 is further deteriorated. Therefore, it is very necessary to optimize the similar oxide transistors M2.

In order to solve the above problem, an embodiment of the present application provides a gate driving circuit. The gate driving circuit, at the reset stage, under the time-division alternating controlling by the reset signals of the first reset-signal line Reset A and the second reset-signal line Reset B, writes the power-supply signals in the power-supply-signal lines into the first node in a time-division alternating mode. Particularly, referring to FIG. 13, the transistor M1 is electrically connected to the signal line Input and the first node PU, and is configured for, under the controlling by the Input signal of the signal line Input, writing the Input signal of the signal line Input into the first node PU and the capacitor C. The transistor M3 is electrically connected to the clock-signal line CLK, the first node PU and the capacitor C, and is configured for, under the controlling by the Input signal of the first node PU, writing the CLK signal of the clock-signal line CLK into the output-signal line Gout. The transistor M2A is electrically connected to the signal line RESET A and the power-supply-signal line LVGL, and is configured for, under the controlling by the RESET signal of the signal line RESET A, writing the LVGL signal of the power-supply-signal line LVGL into the first node PU. The transistor M2B is electrically connected to the signal line RESET B and the power-supply-signal line LVGL, and is configured for, under the controlling by the RESET signal of the signal line RESET B, writing the LVGL signal of the power-supply-signal line LVGL into the first node PU. The transistor M4A is electrically connected to the signal line RESET B and the power-supply-signal line VGL, and is configured for, under the controlling by the RESET signal of the signal line RESET B, writing the VGL signal of the power-supply-signal line VGL into the first node PU. The transistor M4B is electrically connected to the signal line RESET A and the power-supply-signal line VGL, and is configured for, under the controlling by the RESET signal of the signal line RESET A, writing the VGL signal of the power-supply-signal line VGL into the first node PU.

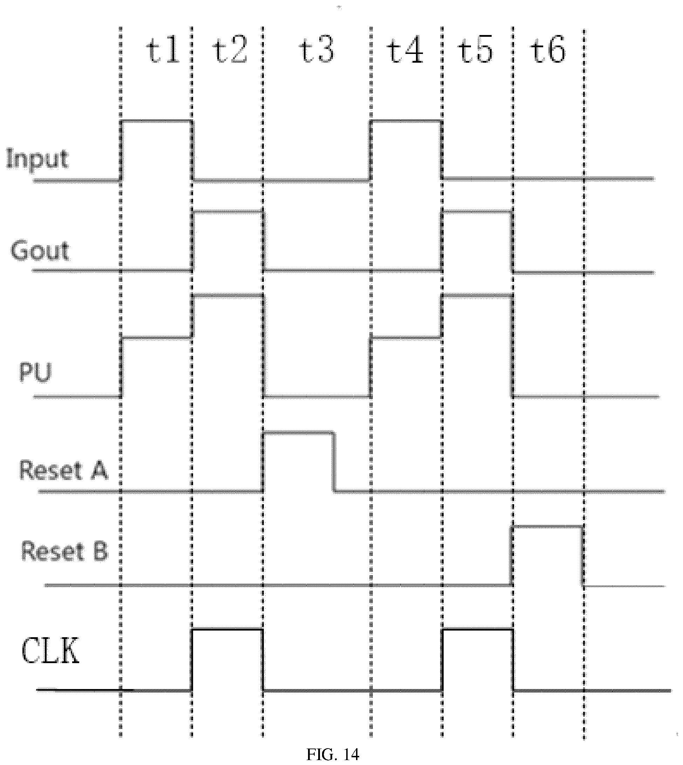

Referring to FIG. 14, at the stage t1, a high level is inputted into the signal line Input, and at this point the transistor M1 is turned on, the first node PU is pulled up to a high level, and the capacitor C is charged. At the stage t2, the transistor M3 is turned on, to input a high level into the clock-signal line CLK, and at this point the output-signal line Gout outputs a high level. Because of the bootstrapping effect of the capacitor C, the first node PU is boosted again. At the stage t3, a high level is inputted into the signal line RESET A, and at this point the transistor M2A and the transistor M4B are turned on, to write the low levels inputted by LVGL and VGL respectively into the first node PU, and pull down the first node PU to a low level, and the output-signal line Gout outputs a low level. At the stage t4, a high level is inputted into the signal line Input, and at this point the transistor M1 is turned on, the first node PU is pulled up to a high level, and the capacitor C is charged. At the stage t5, the transistor M3 is turned on, to input a high level into the clock-signal line CLK, and at this point the output-signal line Gout outputs a high level. Because of the bootstrapping effect of the capacitor C, the first node PU is boosted again. At the stage t6, a high level is inputted into the signal line RESET B, and at this point the transistor M2B and the transistor M4A are turned on, to write the low levels inputted by LVGL and VGL respectively into the first node PU, and pull down the first node PU to a low level, and the output-signal line Gout outputs a low level.

In the gate driving circuit according to the embodiments of the present application, within consecutive time-sequence periods, one transistor in the reset unit is turned on alternately, wherein particularly, at the reset stage of the first period the transistor M2A and the transistor M4B shown in FIG. 13 are turned on, and at the reset stage of the second period the transistor M2B and the transistor M4A shown in FIG. 13 are turned on, which is circulated and repeated. As compared with the related art, in which merely one transistor M2 and one transistor M4 are provided, the gate driving circuit according to the embodiments of the present application can highly reduce the time quantity of the usage of the transistors in the reset unit, thereby improving the characteristics of the transistors, preventing characteristic damage of the transistors caused by the high Vds voltage difference and repeated usage of the transistors, ensuring the stability of the transistors, and preventing the imperfect of abnormal Gout output to the largest extent, so as to effectively improve the image quality.

In addition, if allowed by the design room of the displaying base board, it is configured that the sizes of the transistor M2 and the transistor M4 range 60µm-90µm, for example, 60µm, 70µm, 80µm or 90µm, to further improve the anti-damage capacity of the transistor M2 and the transistor M4.

Furthermore, referring to FIG. 13, the capacitor C is provided between the first node PU and the transistor M3, which can effectively reduce the probability of heat-generation imperfect of the transistor M3.

It should be noted that, firstly, the above-described reliability test is a reliability test for display products, wherein the test items are usually a high-temperature-high-humidity-environment test, a high-temperature action test, a low-temperature action test and so on.

Secondly, the first node is defined merely for the purpose of facilitating the description on the circuit structure, and the first node is not a practical circuit unit.

Thirdly, in order to uniform the fabricating process, and facilitate to simplify the subsequent circuit driving method, the transistors M1 to M4 are N-type transistors. Certainly, all of the transistors may also be P-type transistors. In the case in which the transistors are P-type transistors, the design principle is similar to that of the present application, and also falls within the protection scope of the present application.

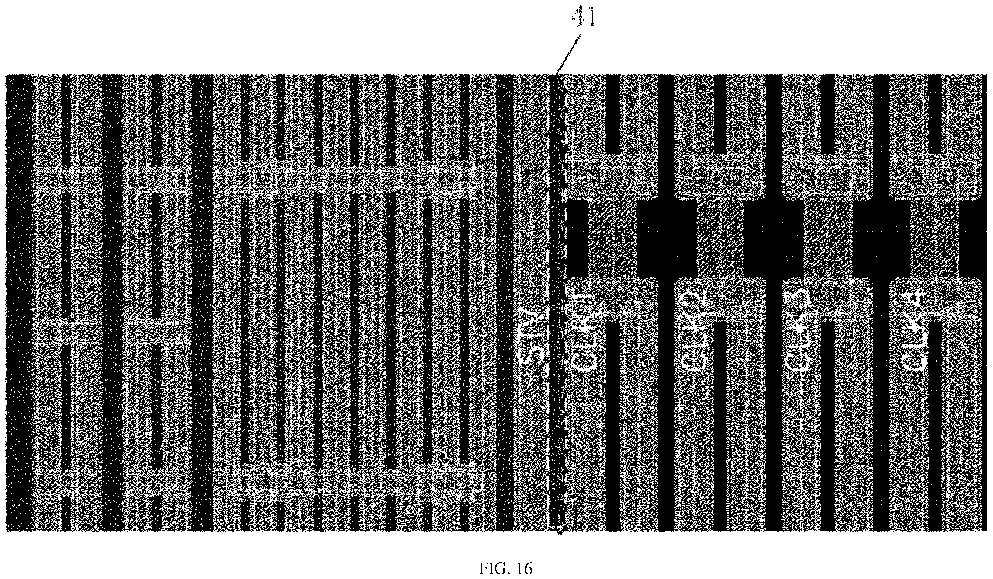

An embodiment of the present application provides a slot structure. Optionally, referring to FIG. 16, the displaying base board further comprises an organic layer located on the side of the second electrically conducting part that is farther from the first electrically conducting part, the organic layer has an extending-throughout slot 41, and the slot 41 is located on the side of all of the clock-signal lines CLK that is farther from the driving circuit.

The material of the organic layer is an organic material. The particular type of the organic material is not limited herein, and may be decided particularly according to product demands.

The quantity of the slot is not limited herein. As an example, the quantity of the slot may be 1. Alternatively, the quantity of the slot may also be plural. If the quantity is plural, the plurality of slots may be arranged separately, and may also be in communication.

The position of the slot is not limited herein. As an example, the slot may be provided merely on the side of the displaying region that has the driving circuit. Alternatively, the slot may surround the displaying region by one circle.

It should be noted that the direction of extension of the slot is perpendicular to the first direction (the direction OA), and parallel to the plane where the substrate is located.

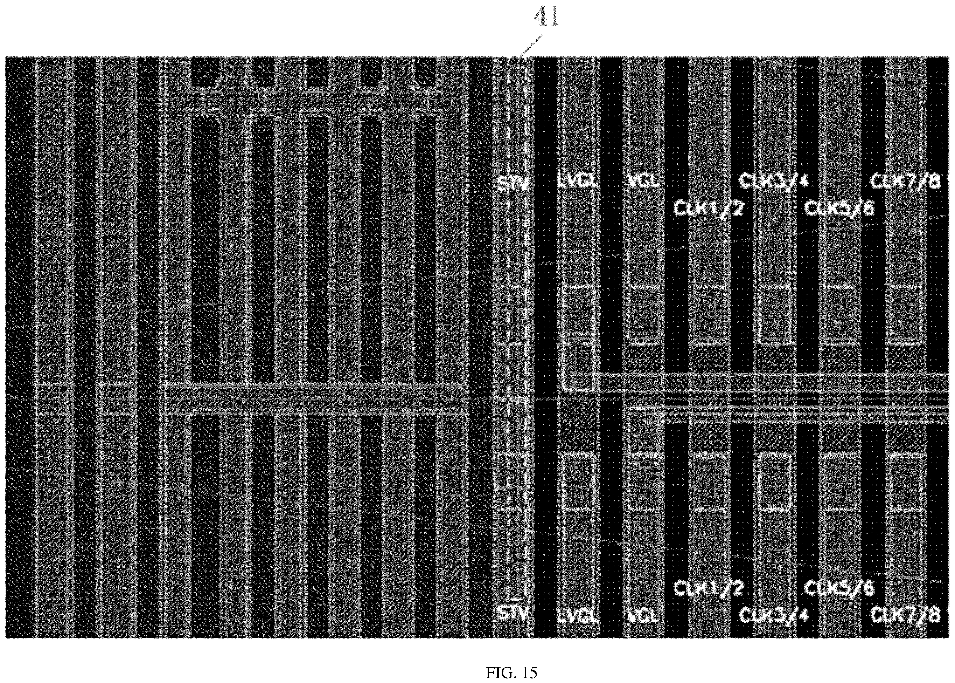

In the related art, referring to FIG. 15, the slot (ORG slot) in the organic layer is usually provided in the STV wiring. In the case in which the wiring according to the present application is of a double-layer structure and the double layers are connected in parallel by a via hole, if the ORG slot is provided in the wiring of a double-layer structure, water vapor and oxygen invade the position of the via hole via the ORG slot, which results in corrosion at the via hole to have imperfect, and accordingly results in displaying transverse-stripe imperfect.

In the displaying base board according to the embodiments of the present application, by providing the ORG slot between the input-signal line STV and the clock-signal lines CLK, it is effectively prevented that water vapor and oxygen invade the position of the via hole of the double-layer wiring via the ORG slot, so as to prevent reliability imperfect.

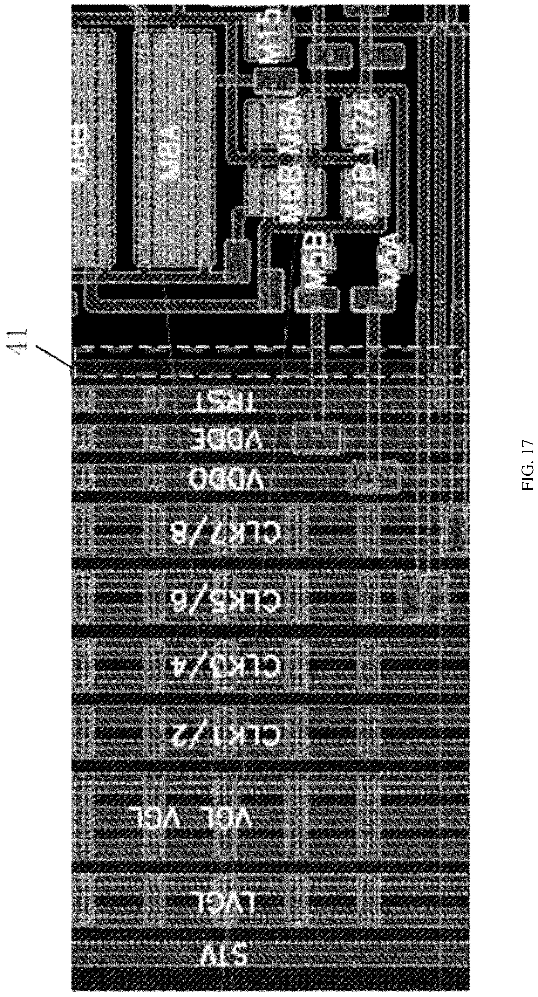

An embodiment of the present application provides another slot structure. Referring to FIG. 17, the displaying base board further comprises an organic layer located on the side of the second electrically conducting part that is farther from the first electrically conducting part, the organic layer has an extending-throughout slot 41, and the slot 41 is located between the plurality of wirings and the driving circuit. By configuring the position of the ORG slot between the driving circuit and the clock-signal lines CLK, it is effectively prevented that water vapor and oxygen invade the position of the via hole of the double-layer wiring via the ORG slot, and at the same time water vapor and oxygen are effectively isolated from entering and corroding the transistors in the shift registers, so as to further prevent reliability imperfect.

It should be noted that it must be ensured that the organic layer on the transistors in the shift registers exists, and the ORG slot cannot be made in the transistors, so as to more effectively protect the good performance of the transistors.

Optionally, referring to FIGS. 1 and 2, the plurality of wirings further include at least an input-signal line STV and a reset-signal line TRST, and the input-signal line STV is located on the side of all of the clock-signal lines CLK that is farther from the driving circuit 1. Both of the input-signal line STV and the reset-signal line TRST are located between all of the clock-signal lines CLK and the driving circuit 1. Therefore, the signals can be inputted into the driving circuit via the input-signal line STV, and it can be caused that merely one clock-signal line crosses the at least one of the power-supply-signal lines that is closer to the displaying region than the clock-signal line is, which can greatly reduce the overlapping capacitance, thereby effectively ensuring the performance of the displaying base board.

An embodiment of the present application further provides a displaying device, wherein the displaying device comprises the displaying base board stated above.

The displaying device may be a flexible displaying device (also referred to as a flexible screen), and may also be a rigid displaying device (i.e., a display screen that cannot be bent), which is not limited herein. The displaying device may be an LCD (Liquid Crystal Display) displaying device, and may also be an OLED (Organic Light Emitting Diode) displaying device. The displaying device may be any product or component that has the function of displaying, such as a television set, a digital camera, a mobile phone and a tablet personal computer. The displaying device may also be applied in fields such as identity identification and medical equipment, and the products that have already been promoted or have a good prospect of promotion include security identity authentication, smart door locks, medical video collection and so on. The displaying device has the advantages such as a high refresh rate, a low power consumption, a good stability, a good effect of displaying, a long life, a high stability, a high contrast, a good imaging quality and a high product quality.

It should be noted that all of the embodiments of the present application illustrate by taking the case as an example in which the displaying device is an LCD displaying device.

In the displaying device according to the embodiments of the present application, by configuring that the at least one of the power-supply-signal lines is closer to the displaying region than the at least one of the clock-signal lines is, because the clock-signal lines input the signals line by line, it can be caused that merely one clock-signal line crosses the at least one of the power-supply-signal lines that is closer to the displaying region than the clock-signal line is, which can greatly reduce the overlapping capacitance, thereby effectively ensuring the performance of the displaying base board.

The "embodiment" as used herein means that particular features, structures or characteristics described with reference to an embodiment are included in at least one embodiment of the present application.

The description provided herein describes many concrete details. However, it can be understood that the embodiments of the present application may be implemented without those concrete details. In some of the embodiments, well-known processes, structures and techniques are not described in detail, so as not to affect the understanding of the description.

Finally, it should be noted that the above embodiments are merely intended to explain the technical solutions of the present application, and not to limit them. Although the present application is explained in detail with reference to the above embodiments, a person skilled in the art should understand that he can still modify the technical solutions set forth by the above embodiments, or make equivalent substitutions to part of the technical features of them. However, those modifications or substitutions do not make the essence of the corresponding technical solutions depart from the spirit and scope of the technical solutions of the embodiments of the present application.

## Claims

1. A displaying base board, wherein the displaying base board comprises a displaying region and a peripheral region surrounding the displaying region;
the peripheral region comprises a plurality of wirings and a driving circuit that is located on one side of the displaying region, and all of the plurality of wirings are electrically connected to the driving circuit, and are located on any one of two opposite sides of the driving circuit in a first direction, wherein the first direction refers to a direction from the displaying region pointing to the driving circuit;
the plurality of wirings include at least a plurality of clock-signal lines and a plurality of power-supply-signal lines; and
a spacing between at least one instance of the power-supply-signal lines and the displaying region in the first direction is less than a spacing between at least one instance of the clock-signal lines and the displaying region in the first direction.

2. The displaying base board according to claim 1, wherein the driving circuit is located between the displaying region and the plurality of wirings; and
all of the power-supply-signal lines are located between all of the clock-signal lines and the driving circuit.

3. The displaying base board according to claim 1, wherein the driving circuit comprises a plurality of shift registers that are cascaded;
at least one instance of the wirings comprises a plurality of first line segments and second line segments, and a quantity of the plurality of first line segments is equal to a quantity of the plurality of shift registers; and
neighboring instances of the first line segments are electrically connected by the second line segments.

4. The displaying base board according to claim 3, wherein a width of each of the second line segments in the first direction is less than a width of each of the first line segments in the first direction.

5. The displaying base board according to claim 3, wherein each of the first line segments comprises a first sub-line segment and a second sub-line segment that are connected in parallel and arranged side by side, and each of the first sub-line segment and the second sub-line segment is of a double-layer structure.

6. The displaying base board according to claim 5, wherein each of the first sub-line segment and the second sub-line segment comprises a first electrically conducting part and a second electrically conducting part that are arranged sequentially in stack; and
the first electrically conducting part and the second electrically conducting part are connected by a via hole; or
the first electrically conducting part and the second electrically conducting part directly contact.

7. The displaying base board according to claim 6, wherein each of the first sub-line segment and the second sub-line segment further comprises an insulating part provided between the first electrically conducting part and the second electrically conducting part, the insulating part has the via hole, and the first electrically conducting part is electrically connected to the second electrically conducting part by the via hole in the insulating part.

8. The displaying base board according to claim 6, wherein each of the second line segments is of a single-layer structure, and is provided in a same one layer as the second electrically conducting part.

9. The displaying base board according to claim 8, wherein all of the clock-signal lines and some of the power-supply-signal lines are of a double-layer structure.

10. The displaying base board according to claim 1, wherein the displaying base board further comprises a substrate, and both of the displaying region and the peripheral region are located on the substrate;
the driving circuit comprises a shift register, the shift register comprises a first transistor group and a second transistor group, and the first transistor group is located between the second transistor group and the plurality of wirings; and
the first transistor group comprises a plurality of first transistors, the second transistor group comprises a plurality of second transistors, and an area of an orthographic projection on the substrate of each of the first transistors is less than an area of an orthographic projection on the substrate of each of the second transistors.

11. The displaying base board according to claim 10, wherein a spacing in the first direction from the first transistor group to a wiring of a lowest distance among all of the wirings is greater than or equal to 50µm.

12. The displaying base board according to claim 10, wherein an active layer of any one of transistors in the first transistor group and the second transistor group comprises a plurality of discrete active parts.

13. The displaying base board according to claim 1, wherein the driving circuit comprises a shift register, the shift register comprises a reset unit, and the reset unit is electrically connected to a first reset-signal line, a second reset-signal line, the power-supply-signal lines, and a first node, and is configured for, at a reset stage, under time-division alternating controlling by reset signals of the first reset-signal line and the second reset-signal line, writing power-supply signals in the power-supply-signal lines into the first node in a time-division alternating mode.

14. The displaying base board according to claim 8, wherein the displaying base board further comprises an organic layer located on one side of the second electrically conducting part that is farther from the first electrically conducting part, the organic layer has an extending-throughout slot, and the slot is located on one side of all of the clock-signal lines that is farther from the driving circuit; or
the slot is located between the plurality of wirings and the driving circuit.

15. The displaying base board according to claim 2, wherein the plurality of wirings further include at least an input-signal line and a reset-signal line, and the input-signal line is located on one side of all of the clock-signal lines that is farther from the driving circuit; and
both of the input-signal line and the reset-signal line are located between all of the clock-signal lines and the driving circuit.

16. A displaying device, wherein the displaying device comprises the displaying base board according to any one of claims 1-15.
